# EUROPEAN PATENT APPLICATION

(11) **EP 3 503 216 A1**
(43) Date of publication of application: **26.06.2019**
(21) Application number: 18180855.1
(22) Date of filing: 29.06.2018
(51) Int. Cl.: H01L 31/049

(54) **SOLAR PHOTOVOLTAIC MODULE**

(30) Priority: 25.12.2017 CN 201721833148 U
(71) Applicant: Miasole Photovoltaic Technology Co., Ltd., 100107 Beijing (CN)
(72) Inventor: AO, Huaming, Beijing, 100107 (CN)
(74) Representative: Nony

(57) **Abstract**

The disclosure provides a solar photovoltaic module, including a glass front plate, a first packaging adhesive film, a solar cell layer, a second packaging adhesive film, a waterproof layer, a bonding layer and a polymer back plate which are bonded successively. In the solar photovoltaic module provided in the disclosure, the glass front plate with strong rigidity and a flexible polymer back plate with light weight are arranged at two sides of the solar photovoltaic module respectively, thereby reducing the overall weight of the solar photovoltaic module. Meanwhile, the overall rigidity of the solar photovoltaic module can be ensured through the glass back plate, thereby enhancing applicability of the solar photovoltaic module in various products.

## Description

### TECHNICAL FIELD

The disclosure relates to the technical field of solar power generation, and particularly relates to a solar photovoltaic module.

### BACKGROUND

With the rapid development of solar power generation technologies, the solar power generation technologies are applied to more and more products. However, to ensure that the solar photovoltaic module has a long service life in various products, packaging of a solar cell module is very important. Most of existing solar photovoltaic assemblies take two glass plates as main packaging material, i.e., a front side and a back side of the solar cell module each are provided with a glass plate, so that the photovoltaic assembly has a high rigidity. However, due to the heavy weight of the two glass plates, the solar photovoltaic module may have a heavy overall weight and is not applicable to some products with weak bearing capacity. In addition, fully-flexible material may also adopted for packaging the existing photovoltaic component, but packaging with the flexible material may greatly reduce rigidity and pressure resistance of the photovoltaic assembly, increasing a damage risk of the photovoltaic assembly.

### SUMMARY

An objective of the present disclosure is to provide a solar photovoltaic module to solve above problems in the existing art and reduce the weight of the photovoltaic assembly while the ensuring rigidity and pressure resistance of the photovoltaic assembly.

The present disclosure provides a solar photovoltaic module, including a glass front plate, a first packaging adhesive film, a solar cell layer, a second packaging adhesive film, a waterproof layer, a bonding layer and a polymer back plate which are bonded successively.

In the above solar photovoltaic module, the solar photovoltaic module further includes an insulating layer, and the insulating layer is respectively bonded with the waterproof layer and the second packaging adhesive film.

In the above solar photovoltaic module, the waterproof layer is a metal film.

In the above solar photovoltaic module, the metal film is a composite layer of polyethylene terephthalate (PET) and an aluminum foil.

In the above solar photovoltaic module, the solar photovoltaic module further includes a sealing ring layer, an upper end surface of the sealing ring layer encircles an edge of the glass front plate, and a lower end surface of the sealing ring layer encircles an edge of the waterproof layer.

In the above solar photovoltaic module, the solar photovoltaic module further includes a plurality of diodes. The solar cell layer includes a plurality of electrically interconnected solar cells; and each of the plurality of diodes is connected in parallel to a set quantity of solar cells among the plurality of solar cells.

In the above solar photovoltaic module, each of the first packaging adhesive film and the second packaging adhesive film is one of a ethylene-vinyl acetate copolymer (EVA) adhesive film, a polyolefin elastomer (POE) adhesive film or a polyvinylbutyral (PVB) adhesive film.

In the above solar photovoltaic module, the polymer back plate is made of one of ethylene-tetra-fluoro-ethylene (ETFE), polyvinylidene fluoride (PVDF) and PET.

In the above solar photovoltaic module, the solar cell layer is one of a copper-indium-gallium-selenium solar cell, a copper-indium- selenium solar cell, a gallium-arsenide solar cell, a cadmium-telluride solar cell, and a dye-sensitized solar cell.

In the solar photovoltaic module provided in the disclosure, one side of the solar photovoltaic module is provided with the glass front plate with strong rigidity, and the other side of the solar photovoltaic module is provided with the flexible polymer back plate with light weight, thereby reducing an overall weight of the solar photovoltaic module. Meanwhile, the overall rigidity of the solar photovoltaic module can be ensured through the glass back plate, thereby enhancing applicability of the solar photovoltaic module in various products. In addition, the waterproof layer is arranged so as to effectively prevent water vapor from permeating from the back plate side, thereby effectively solving a problem that the water vapor permeates into a solar panel, enhancing the performance of the solar panel and prolonging the service life of the solar cell layer.

### BRIEF DESCRIPTION OF DRAWINGS

FIG. 1 is a structural schematic diagram illustrating a solar photovoltaic module provided in an embodiment of the disclosure; and
FIG. 2 is a schematic diagram illustrating a diode and solar cells which are connected in parallel.

### List of reference numerals:

100-glass front plate
200-first packaging adhesive film
300-solar cell layer 310-solar cell
400-second packaging adhesive film
500-waterproof layer
600-bonding layer
700-polymer back plate
800-sealing ring layer
900-diode

### DETAILED DESCRIPTION

Embodiments of the disclosure are described below in detail. Examples of the embodiments are shown in drawings. In the drawings, same or like numerals refer to same or like elements throughout, or refer to elements with same or like functions. Embodiments described below with reference to drawings are exemplary, are only used for explaining the disclosure, and shall not be explained as a limitation to the disclosure.

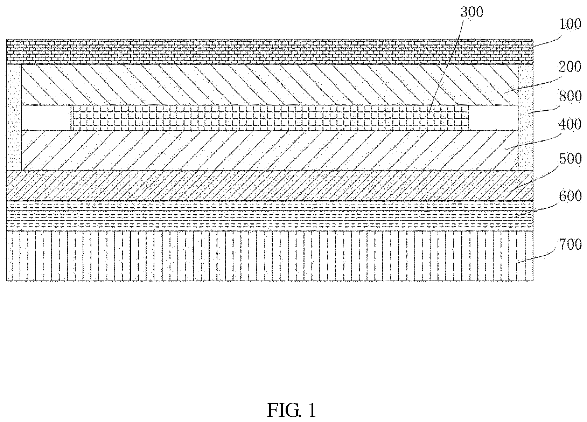

As shown in FIG. 1, embodiments of the present disclosure provide a solar photovoltaic module. The solar photovoltaic module includes a glass front plate 100, a first packaging adhesive film 200, a solar cell layer 300, a second packaging adhesive film 400, a waterproof layer 500, a bonding layer 600 and a polymer back plate 700 which are bonded successively. The polymer back plate 700 is made of flexible material with light weight. The glass front plate 100 with strong rigidity is arranged at one side of the solar photovoltaic module, and the flexible polymer back plate 700 with light weight is arranged at the other side, thereby reducing an overall weight of the solar photovoltaic module. Meanwhile, with the glass back plate, the overall rigidity of the solar photovoltaic module can be ensured, thereby enhancing applicability of the solar photovoltaic module in various products.

Since the solar photovoltaic module is often used outdoors and is easy to be eroded by rain, snow and the like, performance of the solar cell layer 300 in the solar panel is degraded rapidly. Therefore, to solve this problem, in the present embodiment, the waterproof layer 500 is arranged so as to effectively prevent water vapor from permeating from the polymer back plate 700 side, thereby effectively solving a problem that the water vapor infiltrating into the solar panel, enhancing performance of the solar panel and prolonging the service life of the solar cell layer 300. In addition, relative to an ordinary polymer composite waterproof layer, the above waterproof layer 500 enhances the pressure resistance of the solar cell layer 300. In an exemplary embodiment, the waterproof layer 500 is a metal film, such as a composite layer of PET and an aluminum foil.

Further, the solar photovoltaic module may also include an insulating layer, and the insulating layer is respectively bonded with the waterproof layer 500 and the second packaging adhesive film 400. With the insulating layer, the high voltage resistance of the solar photovoltaic module is effectively enhanced and a risk of electric leakage is avoided.

The first packaging adhesive film 200 has properties such as insulation and ultraviolet absorption, and can effectively protect other materials of the assembly below the first packaging adhesive film.

Further, the solar photovoltaic module also includes a sealing ring layer 800 An upper end surface of the sealing ring layer 800 encircles an edge of the glass front plate 100, and a lower end surface of the sealing ring layer 800 encircles an edge of the waterproof layer 500. Thus, a sealed space is formed by the glass front plate 100, the waterproof layer 500 and the sealing ring layer 800. The first packaging adhesive film 200, the solar cell layer 300 and the second packaging adhesive film 400 are packaged in the sealed space, thereby enhancing protection for the solar cell layer 300. The sealing ring layer 800 may be fixedly bonded with the edge of the first packaging adhesive film 200 and the edge of the second packaging adhesive film 400, thereby enhancing the packaging reliability for the solar cell layer 300. The sealing ring layer 800 may be a butyl rubber layer.

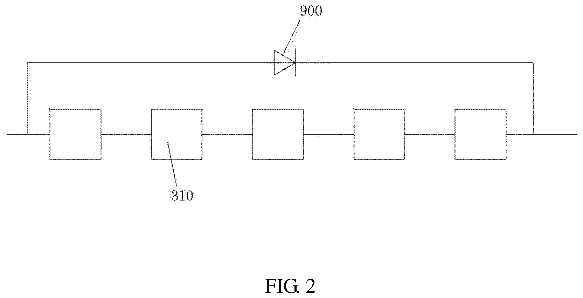

Further, as shown in FIG. 2, the solar photovoltaic module further includes a plurality of diodes 900, and the solar cell layer 300 includes a plurality of solar cells 310. The plurality of solar cells 310 are connected in series or in parallel, and each of the plurality of diodes 900 is connected with a set quantity of solar cells in parallel. To facilitate description, a configuration in which the solar cells 310 are connected in series is described in the present embodiment. When the solar cells 310 are operated normally, the diode 900 is in the reverse off state and do not generate any effect on a circuit. If one of the solar cells 310 connected in parallel with the diodes 900 is not operated normally, the current of the solar cells 310 connected in series is determined by one of the solar cells 310 with minimum current. The magnitude of the current is determined by a shielding area of the solar cell 310. If reverse bias is greater than a minimum voltage of the solar cells 310, the diode 900 is turned on. At this moment, the solar cell 310 which is not operated normally is short-circuited, thereby ensuring normal operation of the solar photovoltaic module.

In an exemplary embodiment, each solar cell 310 may be connected with one diode 900 in parallel for a better protection and reducing the quantity of failed solar cells 310 in an abnormal state. However, due to an influence of price and cost of the diodes 900, dark current loss and existence of voltage drop in an operating state, every five solar cells 310 may be connected with one diode 900 in parallel.

Specifically, the bonding layer 600 may be an adhesive film with certain ultraviolet resistance, aging resistance and high cohesiveness, and is preferably EVA hot melt adhesive film in the present embodiment. The EVA hot melt adhesive film has strong adhesion and durability, can ensure a stable bonding between the polymer back plate 700 and the waterproof layer 500, and can also resist high temperature, moisture and ultraviolet rays. The polymer back plate 700 may be made of one of ETFE, PVDF and PET.

Specifically, the first packaging adhesive film 200 and the second packaging adhesive film 400 have certain bonding strength, to play a role of ensuring that the glass front plate 100 and the polymer back plate 700 can be firmly and reliably bonded with the solar cell layer 300. In addition, the first packaging adhesive film 200 and the second packaging adhesive film 400 prevent outside environment from affecting the performance of the solar cell layer 300. Meanwhile, the first packaging adhesive film 200 and the second packaging adhesive film 400 also have a high light transmittance performance, so as to improve power generation performance and conversion efficiency of the solar cell layer 300. Specifically, the first packaging adhesive film 200 and the second packaging adhesive film 400 may be an EVA adhesive film, a POE adhesive film or a PVB adhesive film. In the present embodiment, the first packaging adhesive film 200 and the second packaging adhesive film 400 are preferably POE adhesive film. The POE adhesive film is a copolymer of ethylene and octene and of saturated fat chain structure, has fewer tertiary carbon atoms in molecular chain, and presents good weatherability, good ultraviolet resistance, good aging resistance, excellent heat resistance and excellent low temperature resistance. Therefore, the POE adhesive film has better aging resistance than the EVA adhesive film. Of course, the first packaging adhesive film 200 and the second packaging adhesive film 400 may also be made of other materials with above properties, which is not limited in the present embodiment.

Specifically, the solar cell layer 300 may be one of copper indium gallium selenium solar cell, copper indium selenium solar cell, gallium arsenide solar cell, cadmium telluride solar cell, and dye-sensitized solar cell. However, to enhance a light absorption capability of the solar cell layer 300 and improve the photoelectric conversion efficiency and the power generation stability, the solar cell layer 300 is a flexible copper indium gallium selenium solar cell.

It can be understood by those skilled in the art that, to clearly illustrate all layers of the heterojunction solar cell, the thickness of each layer in FIG. 1 is not drawn to scale.

In the solar photovoltaic module provided in embodiments of the present disclosure, the glass front plate with strong rigidity is arranged at one side of the solar photovoltaic module, and the flexible polymer back plate with light weight is arranged at the other side, thereby reducing the overall weight of the solar photovoltaic module. Meanwhile, with the glass back plate, the overall rigidity of the solar photovoltaic module can be ensured, thereby enhancing the applicability of the solar photovoltaic module in various products. In addition, with the waterproof layer, water vapor is effectively prevented from permeating from the back plate side, thereby effectively solving a problem of water vapor penetration, enhancing the performance of the solar panel and prolonging the service life of the solar cell layer.

Structures, features and effects of the present disclosure are described above in detail based on embodiments shown in drawings, and the above only describes exemplary embodiments of the present disclosure. However, the implementation scopes of the present disclosure is not limited by the drawings. Any change made in accordance with concepts of the disclosure or any equivalent embodiment modified as equivalent change shall be included in a protection scope of the disclosure in case of not going beyond spirits covered by the description and drawings.

## Claims

1. A solar photovoltaic module, comprising a glass front plate (100), a first packaging adhesive film (200), a solar cell layer (300), a second packaging adhesive film (400), a waterproof layer (500), a bonding layer (600) and a polymer back plate (700) which are bonded successively.

2. The solar photovoltaic module according to claim 1, further comprising an insulating layer, wherein the insulating layer is respectively bonded with the waterproof layer (500) and the second packaging adhesive film (400).

3. The solar photovoltaic module according to claim 1, wherein the waterproof layer (500) is a metal film.

4. The solar photovoltaic module according to claim 3, wherein the metal film is a composite layer of Polyethylene terephthalate (PET) and an aluminum foil.

5. The solar photovoltaic module according to claim 1, further comprising a sealing ring layer (800), wherein an upper end surface of the sealing ring layer (800) encircles an edge of the glass front plate (100); and a lower end surface of the sealing ring layer (800) encircles an edge of the waterproof layer (500).

6. The solar photovoltaic module according to claim 1, further comprising a plurality of diodes (900), wherein the solar cell layer (300) comprises a plurality of electrically interconnected solar cells (310), and each of the plurality of diodes (900) is connected in parallel to a set quantity of solar cells among the plurality of solar cells (310).

7. The solar photovoltaic module according to claim 1, wherein the first packaging adhesive film (200) is one of a ethylene-vinyl acetate copolymer (EVA) adhesive film, a polyolefin elastomer (POE) adhesive film and a polyvinylbutyral (PVB) adhesive film, and the second packaging adhesive film is one of a EVA adhesive film, a POE adhesive film and a PVB adhesive film.

8. The solar photovoltaic module according to claim 1, wherein the polymer back plate (700) is made of one of ethylene-tetra-fluoro-ethylene (ETFE), polyvinylidene fluoride (PVDF) and PET.

9. The solar photovoltaic module according to claim 1, wherein the solar cell (310) is one of a copper-indium-gallium-selenium solar cell, a copper-indium-selenium solar cell, a gallium-arsenide solar cell, a cadmium-telluride solar cell, and a dye-sensitized solar cell.
